Europäisches Patentamt

European Patent Office

Office européen des brevets

(11) Veröffentlichungsnummer: **0 326 540**
**A2**

# (12) EUROPÄISCHE PATENTANMELDUNG

(21) Anmeldenummer: **89890018.8**

(22) Anmeldetag: **25.01.89**

(51) Int. Cl.4: **G 03 B 41/00**

(30) Priorität: **26.01.88 AT 139/88**

(43) Veröffentlichungstag der Anmeldung:
**02.08.89 Patentblatt 89/31**

(84) Benannte Vertragsstaaten: **DE FR GB**

(71) Anmelder: **Thallner, Erich, Dipl.-Ing.**
**Bubing 71**
**A-4780 Schärding (AT)**

(72) Erfinder: **Thallner, Erich, Dipl.-Ing.**
**Bubing 71**
**A-4780 Schärding (AT)**

(74) Vertreter: **Hübscher, Heiner, Dipl.-Ing. et al**
**Spittelwiese 7**
**A-4020 Linz (AT)**

(54) **Belichtungseinrichtung für lichtempfindliche Materialien.**

(57) Bei einer Belichtungseinrichtung für lichtempfindliche Materialien mit wenigstens einer Lampe (1) mit nachgeordneter Projektionseinrichtung (2, 4, 7, 9) zur flächigen Belichtung des auf einem Substratträger (13) abstützbaren Substrates durch eine ein Belichtungsmuster bestimmende Projektionsmaske erzeugt die Projektionseinrichtung (2, 4, 7, 9) einen nur über einen Bruchteil der zu belichtenden Fläche reichenden Lichtstreifen (10). Der Substratträger (13) mit dem Substrat (12) ist über Stelleinrichtungen in eine Sollage gegenüber der Projektionsmaske ausrichtbar und gemeinsam mit diesen Teilen quer zum erzeugten Lichtstreifen (10) verschiebbar angebracht, so daß der Lichtstreifen den gesamten zu belichtenden Bereich des Substrates (12) bestreicht. Im Projektionsweg (3, 5, 10) sind Stellglieder (18, 19) zur teilweisen Abschattung von Randbereichen des Lichtstreifens und damit der für die Belichtung wirksamen Breite des Lichtstreifens in dessen verschiedenen Längsbereichen vorgesehen.

*FIG.1*

EP 0 326 540 A2

# Beschreibung

## Belichtungseinrichtung für lichtempfindliche Materialien

Die Erfindung betrifft eine Belichtungseinrichtung gemäß dem Oberbegriff des Patentanspruches 1.

Belichtungseinrichtung dieser Art werden unter anderem bei der Herstellung bzw. Teilherstellung von Bausteinen der Mikroelektronik, sogenannten Mikrochips, die integrierte Schaltkreise, Module, Rechnerbausteine usw. bilden können, verwendet, um die Schaltung bzw. wesentliche Teile davon in einem photolithographischen Verfahren auf dem mit einer entsprechend aktivierten Oberflächenbeschichtung versehenen Halbleitersubstrat zu erzeugen. Als Halbleitersubstrat kommen zum Beispiel dünne Scheiben von Siliziumkristallen und dünne Kristallscheiben aus GaAs in Frage. Es ist üblich, auf entsprechend großen Substraten eine Vielzahl gleicher Bausteine bzw. deren Schaltung auf photolithographischem Wege zu erzeugen und dann die Substrate in die einzelnen Mikrochips zu zerschneiden.

Die Belichtung des Substrates durch die Maske erfolgt meist durch Kontaktkopiatur. Es ist aber auch eine Exponierung im Projektionsverfahren möglich. Unter "Lampe" wird eine Einrichtung zur Erzeugung einer elektromagnetischen Wellenstrahlung verstanden. In der vorliegenden Anmeldung werden die für die Herstellung der fertigen Aufnahmen weiterhin benötigten Einrichtungen für die Entwicklung der Aufnahmen und die Bearbeitung der Mikrochips nicht weiter beschrieben. Weitere Anwendungsgebiete von Belichtungseinrichtungen der gegenständlichen Art sind bei der Herstellung von Bildschirmen und bei der Herstellung von Sensoren gegeben.

Eine Belichtungseinrichtung der gegenständlichen Art ist aus der US-Al-4 350 428 bekannt. Dabei ist im Projektionsweg eines von einer Quecksilber-Bogenlampe erzeugten Lichtbündels, welches die gesamte zu belichtende Fläche gleichzeitig ausleuchtet, ein drehend antreibbarer Trommelverschluß vorgesehen, der eine das Lichtbündel völlig durchlassende Lichtdurchtrittsöffnung aufweist, wobei die Belichtungsstärke durch Einregelung der Drehgeschwindigkeit des Trommelverschlusses bestimmt wird.

Um eine möglichst homogene Belichtung zu erreichen, sieht man bei den bekannten, immer die gesamte Fläche gleichzeitig ausleuchtenden Belichtungseinrichtungen im Projektionsweg zwischen Lampe und zu belichtender Fläche Einrichtungen, insbesondere Streueinheiten zur Vergleichmäßigung der Lichtverteilung über den gesamten Querschnitt des projizierten Lichtkegels vor. Zusätzlich können die elektrische oder eine aufgedampfte Metallbeschichtung aufweisende Spiegel zur Ausbledung von Wärmestrahlen Verwendung finden. Trotz dieser aufwendigen Maßnahmen läßt sich keine vollständig gleichmäßige Belichtung erzielen und es kommt auch durch äußere Einflüsse, wie Alterungen der Lampe, Änderungen der Einstellung der optischen Glieder, Änderung der Reflexions-und Lichtdurchlässigkeit der Projektionseinrichtungen zu Änderungen in der Ausleuchtung und damit zu verschieden starken Belichtungen in verschiedenen Projektionsbereichen, wobei Nachjustierungen nur in beschränktem Ausmaß möglich, zeitaufwendig und nicht immer zielführend sind.

Bei einer Belichtung mit parallelgerichtetem Licht durch eine Projektionsmaske kann es an Kanten bzw. Linienstrukturen der Projektionsmaske oder auch an anderen Stellen im Projektionsweg zu Interferenz- und Beugungserscheinungen kommen, was dazu führt, daß die Strukturen der Projektionsmaske nicht ausreichend scharfkantig über die ganze Tiefe der lichtempfindlich gemachten Schicht auf das Substrat bzw. den sonstigen Träger übertragen werden.

Bei sich gattungsmäßig von Belichtungseinrichtungen nach dem Oberbegriff des Patentanspruches 1 unterscheidenden Belichtungseinrichtungen nach der FR-Al-1 515 127 und der US-Al-3 703 858 ist es bekannt, das Strukturmuster von Bausteinen für die Mikroelektronik nicht in der Gesamtheit zu projizieren, sondern mit Hilfe eines Lichtgriffels auf ein strahlungsempfindlich gemachtes Substrat zu zeichnen. Dabei wird über eine Projektionseinrichtung ein feiner Lichtstrahl erzeugt und gegen das Substrat gerichtet, das seinerseits auf einem über Stelltriebe in X- und Y-Richtung verstellbaren Träger ruht. Die Einstellung des Trägers und Unterbrechungen des Lichtstrahles durch einen Verschluß werden über einen Computer nach einem vorgegebenen Programm gesteuert. Die Querschnittsform des projizierten Lichtstrahles wird durch Lochblenden bestimmt, wobei meist eine quadratische Querschnittsform gewählt wird.

Bei Belichtungseinrichtungen der eingangs genannten Art muß eine möglichst genau definierte Lage des Halbleitersubstrates zur Projektionsmaske eingehalten werden, worunter bei der Exponierung im Projektionsverfahren die Einhaltung eines meist gleichbleibenden, genauen Abstandes der Substratoberfläche von der Maske und bei der Exponierung im Kontaktverfahren eine flächige Anlage der Substratoberfläche an der Maske zu verstehen sind. Sowohl die substratseitige Fläche der Maske kann von der durch ihre Halterung bestimmten Ebene als auch die Oberfläche des Substrates von der durch die Substratauflage bestimmten Ebene abweichen. Der letztgenannte Fehler ergibt sich daraus, daß viele Substrate nicht planparallele Oberflächen aufweisen und wird als "Keilfehler" bezeichnet. Für seinen Ausgleich wird nach der DE-C3-26 05 940 vorgesehen, den Substratträger, der in Vertikalrichtung gegenüber einer Halterung für eine Projektionsmaske verstellbar ist, über einen Kugelkopf auf dem entsprechenden Stelltrieb abzustützen. Nach erfolgter Anstellung wird der Kugelkopf arretiert. Aus der DE-A1-27 23 902 ist es bekannt, den Substratträger über wenigstens drei pneumatische Stelltriebe in Vertikalrichtung zu verstellen. Vorher wird in beiden Fällen die Maskenoberfläche auf eine Referenzebene ausgerichtet, wonach das Substrat mittels der Hubeinrichtung für den Substratträger angestellt wird. Es kann grundsätzlich nur mit sehr leichten Substraten gearbeitet werden und in allen Fällen ergibt sich bisher beim unmittelbaren Andrükken des Substrates an die Projektionsmaske die Gefahr, daß die auf Bruch sehr empfindlichen Substrate beschädigt oder zerstört werden.

Aus der EP-A2-0 039 407 ist es bekannt, den Maskenträger mit Fühlern auszustatten, die gegen den Substratträger gerichtet sind. Dabei wird durch Stelltriebe eine Einstellung der Substratoberfläche in eine durch Signale aus den Fühlern definierte Ebene bewerkstelligt. Es ist dabei notwendig, zunächst die Projektionsmaske selbst exakt gegenüber dieser Projektionsebene auszurichten, was auf Schwierigkeiten stößt, da diese Relativlage nicht durch Fühler definiert ist. Genau genommen wird daher die Substratoberfläche nur bezüglich einer definierten Ebene der Maskenhalterung nicht immer aber genau gegenüber der Maskenoberfläche selbst ausgerichtet.

Aufgabe der Erfindung ist die Schaffung einer Belichtungseinrichtung, die mit einfachen Mitteln eine genaue Belichtung der gesamten zu belichtenden Substratfläche gewährleistet und bei der mit einfachen Mitteln auch genaue Nachjustierungen möglich sind. Eine Teilaufgabe der Erfindung besteht darin, mit einfachen Mitteln eine genaue Ausrichtung der Substratoberfläche gegenüber der Maske zu ermöglichen, auch wenn schwere Substrate eingesetzt werden. Eine weitere Teilaufgabe besteht darin, Maßnahmen vorzusehen, die die nachteilige Wirkung von Beugungs- bzw. Interferenzerscheinungen bei der Projektion mit parallelgerichtetem Licht mildern bzw. eliminieren.

Die gestellte Hauptaufgabe wird durch die im Patentanspruch 1 angegebenen Merkmale gelöst.

Für die Erzeugung des Lichtstreifens werden nur wesentlich kleinere Projektionseinrichtungen als für die Erzeugung eines die gesamte Substratfläche gleichzeitig ausleuchtenden Lichtbündels benötigt. Der wesentliche erfinderische Schritt besteht darin, daß kein übermäßig großer Wert auf die Erzeugung einer konstanten Beleuchtungsstärke im Lichtstreifen selbst gelegt, sondern Unterschiede in der Beleuchtungsstärke durch Veränderung der wirksamen Breite des Lichtstreifens ausgeglichen werden, wobei sich die Belichtungszeiten in den verschiedenen Längsbereichen des Schlitzes ändern und so eine gleichmäßige Belichtung erzielt wird. Durch die Einstellung des Substrates in eine Sollage gegenüber der Projektionsmaske (und nicht auf eine gegenüber der Maskenhalterung definierte Projektionsebene) wird die Substrateinstellung genauer und einfacher als bei den bisherigen Ausführungen.

Eine bevorzugte Ausführung der Stellglieder für den Lichtstreifen entnimmt man dem Anspruch 2. Die einstellbaren Wandelemente können dabei nach Art einer Laschenkette gelenkig zusammenhängen. Vorteilhafter ist jedoch eine Ausführung nach Anspruch 3. Neben einer Handbetätigung der Stelltriebe empfiehlt sich im Sinne einer Automatisierung eine Ausbildung der Stelltriebe gemäß Anspruch 4.

Zur Erleichterung der Einstellung der Schlitzbreite in den verschiedenen Längsbereichen kann eine Ausbildung nach Anspruch 5 vorgesehen werden. Als lichtempfindliche Fühler finden dabei Photoelemente, Photozellen oder Phototransistoren Verwendung. Man kann mit Hilfe zusätzlicher lichtempfindlicher Fühler auch die momentane Lichtstärke der Lichtquelle erfassen und Änderungen dieser Lichtstärke, die durch Alterung oder Spannungsschwankungen sowie Verschmutzungen bedingt sein können, durch Änderung der Spaltbreite, der Verschiebegeschwindigkeit des Substrates gegenüber dem Lichtstreifen und falls möglich, durch Änderung der momentanen Betriebsspannung der Lichtquelle ausgleichen.

Es ist bekannt, daß sich viele lichtempfindliche Fühler auch aus der gleichen Produktionsserie hinsichtlich der Empfindlichkeit und in der Kennlinie unterscheiden können, wobei solche Änderungen auch im Laufe der Betriebszeit auftreten. Um eine langwierige Suche bei der Erstbestückung oder bei Reparaturen nach untereinander weitgehend hinsichtlich der Kenndaten ähnlichen Fühlern zu vermeiden und auch während des Betriebes Nachjustierungen vornehmen zu können, kann gemäß Anspruch 6 vorgegangen werden. Durch die gleiche Belichtung der einzelnen Fühler zeigen die Signale der Fühler gegenseitige Unterschiede an, wobei entweder ein Abgleich der Fühler auf gleiche Empfindlichkeit vorgenommen werden kann oder einfacher bei Verwendung einer mit einem Mikrocomputer ausgestatteten Steuereinrichtung den einzelnen Fühlern zugeordnet Korrekturdaten gespeichert werden, nach denen der Computer die Meßdaten der einzelnen Fühler vor der Auswertung im Sinne der Erzeugung von Steuerbefehlen für die Stelltriebe bzw. Antriebseinrichtungen korrigiert.

Die Ausbildung nach Anspruch 7 trägt zur Vermeidung von Abbildungsfehlern durch Beugungs- und Interferenzerscheinungen bei, da durch die Schwingung des optischen Gliedes verhindert wird, daß Beugungs- und Interferenzerscheinungen während der gesamten Belichtungsdauer auf bestimmte Punkte bzw. Bereiche der projizierten Linienstruktur konzentriert blei ben. Diese Maßnahme ist bei der erfindungsgemäßen Belichtungseinrichtung wegen der geringen zu bewegenden Massen der kleinen Projektionseinrichtungen besonders vorteilhaft, könnte aber auch bei herkömmlichen Belichtungseinrichtungen angewendet werden. Eine Möglichkeit der Antriebsausbildung entnimmt man dem Anspruch 8.

Zur Erzeugung von Parallellicht kann man eine Ausbildung der Projektionseinrichtung nach Anspruch 9 vorsehen, wobei dann nach Anspruch 10 zusätzlich vorgegangen werden kann.

Für die Einstellung des Substrates gegenüber der Projektionsmaske wird bevorzugt die Ausführung gemäß Anspruch 11 vorgesehen. Da immer eine Einstellung der Oberseite des Substrates gegenüber der Maske selbst vorgenommen wird, kommt es beim Maskenwechsel und dadurch bedingter anderer Einstellung der Maske zu keinen Schwierigkeiten bzw. Fehlern. Über die Stellmotoren und Mikrometerschrauben ist eine feinfühlige Positionierung auch schwerer Substrate möglich. Muß bei einer Projektion ein definierter Abstand eingestellt werden, sind Parallelverstellungen des Substratträgers mit dem daraufliegenden Substrat durch parallele Betätigung der Mikrometerschrauben über die Schrittmotoren exakt durchführbar. Es wid nocheinmal betont, daß nicht Maske und Substrat gesondert auf eine vorher definierte Referenzebene, sondern die Substratoberseite zu der durch die zum Substrat weisende Maskenseite definierten Ebene ausgerichtet wird.

Eine mögliche Ausführung der Einstelleinrichtung ist im Anspruch 12 angegeben. Um bei dieser Ausführung jede Beschädigungsgefahr für das Substrat und die Maske auszuschließen, kann nach Anspruch 13 vorgegangen werden. Die Ausbildung nach Anspruch 14 erweitert die Einstellmöglichkeiten. Anspruch 15 gibt eine einfache Meßfühlerausbildung an.

Eine andere Konstruktion, die ebenfalls eine exakte Einstellung des Substrates gegenüber der Projektionsmaske gewährleistet, ist in Anspruch 16 angegeben. Der von den Druckfühlern erfaßte Druck ist dem Abstand der Substratoberseite von der Maskenoberseite im Fühlerbereich proportional, so daß nach diesem Druck genau eingestellt werden kann. Die Einstellung der Substratoberseite kann dabei wie in Anspruch 17 angegeben wird, erfolgen. Durch eine Ausführung nach Anspruch 18 werden die Meßfühler besonders auf den in der Projektion ihrer Eintrittsöffnungen wirkenden Druck und damit auf den Effektivabstand von Maske und Substrat zu den Eintrittsöffnungen empfindlich. Man hat bei Verwendung einer Ausbildung nach den Ansprüchen 16 bis 18 die Möglichkeit, entweder die Substratoberseite auf einen genau definierten Abstand von der Maske einzustellen oder das Substrat nach Einstellung dieses Abstandes über die von den Schrittmotoren angetriebenen Stelltriebe parallel zu sich selbst auf eine Sollage zu verstellen. Für die Zeitdauer der nachfolgenden Belichtung kann man die Meßfühler etwa durch Ausführung nach Anspruch 19 aus dem zu exponierenden Bereich entfernen.

Weitere Einzelheiten und Vorteile des Erfindungsgegenstandes entnimmt man der nachfolgenden Zeichnungsbeschreibung.

In der Zeichnung ist der Erfindungsgegenstand beispielsweise veranschaulicht. Es zeigen

Fig. 1 das Schema einer erfindungsgemäßen Belichtungseinrichtung,

Fig. 2 in schematisch-schaubildlicher Darstellungsweise eine Führungsbahn für den Substratträger mit dem Substrat und einem Tragbalken für lichtempfindliche Fühler, wobei die Umrisse eines eine Belichtungsmaske, Stelleinrichtungen und den Substratträger enthaltenden Gehäuses nur schematisch angedeutet wurden,

Fig. 3 ein Blockschaltschema der Belichtungseinrichtung,

Fig. 4 als Detail die Exponiervorrichtung mit Maskenhalterung und Substratträger schematisiert im Längsschnitt,

Fig. 5 eine Draufsicht auf den Deckel der Exponiervorrichtung nach Fig. 4 und

Fig. 6 in größerem Maßstab ein Detail eines zwischen Belichtungsmaske und Substratträger anbringbaren Meßfühlers.

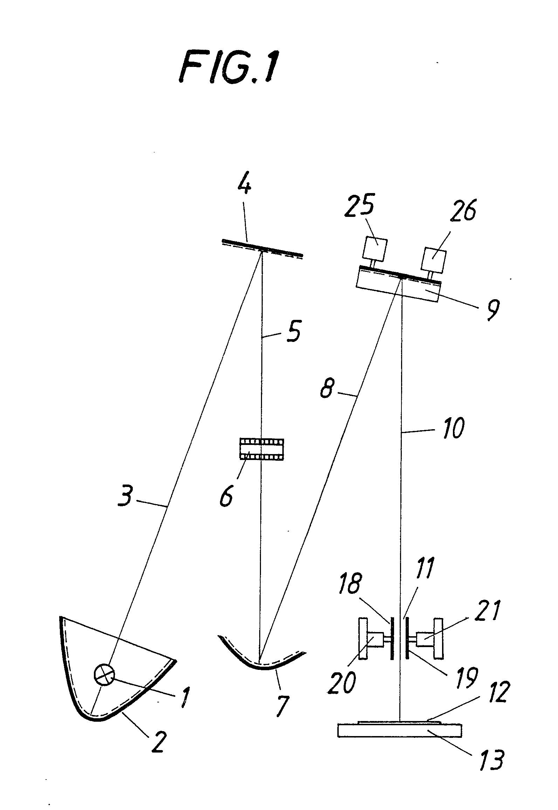

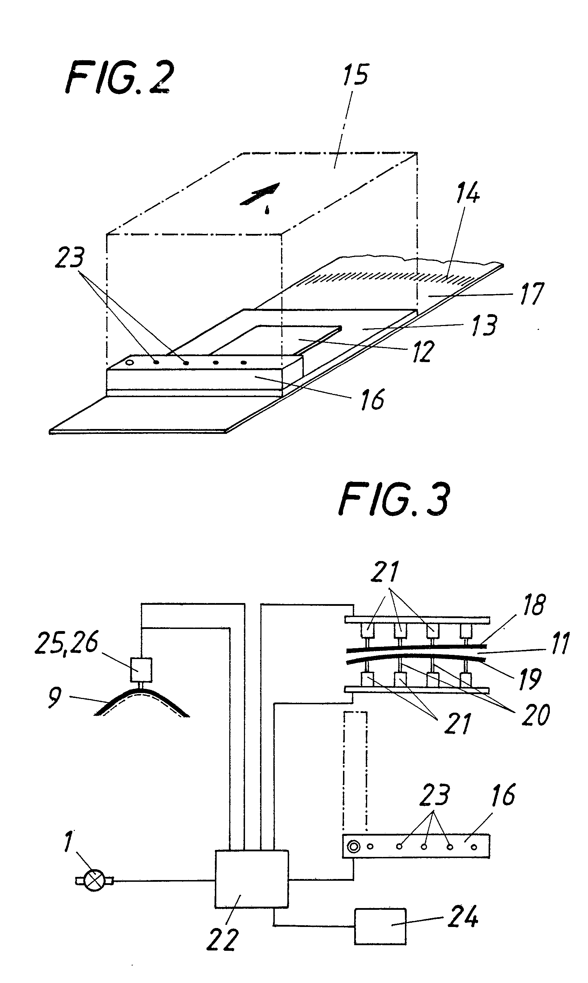

Nach Fig. 1 wird das von einer Lampe 1 abgegebene Licht mit Hilfe eines elliptisch gewölbten Projektionsspiegels 2 in einem Projektionskegel mit der Achse 3 auf einen mit einer aufgedampften Metallbeschichtung versehenen Umlenkspiegel 4 geworfen, der ein sogenannter Kaltlichtspiegel und daher für Wärmestrahlen durchlässig ist und das verlbeibende, im wesentlichen gleiche Wellenlänge aufweisende Licht in einem weiteren Projektionskegel mit der Achse 5 durch einen Wabenkondensor 6 auf einen ersten nur nach einer Ebene gewölbten Parabolspiegel 7 wirft, der durch seine Form das bis dahin konzentrische Lichtbündel in Form eines divergierenden Lichtbandes mit der Achse 8 auf einem weiteren, nur in einer Ebene gewölbten, also rinnenförmigen Parabolspiegel 8 wirft, der gegenüber dem Spiegel 7 um 90° verdreht ist und ein paralleles streifenförmiges Lichtbündel mit der Achse 10 abgibt. Dieser Lichtstreifen 10 wird durch eine Schlitzblende 11 hindurchgeführt, so daß er durch eine in den Fig. 1 und 2 zunächst nicht dargestellte Projektionsmaske hindurch auf ein Halbleitersubstrat 12 bzw. einem Substratträger 13 fällt und im Auftreffbereich einen Lichtstreifen 14 bildet, dessen Ränder durch die momentane Form der Schlitzblende 11 bestimmt sind.

Der Substratträger 13 mit dem Substrat 12 ist in einem Gehäuse 15, das eine Maskenhalterung enthält, angebracht und gemeisam mit diesem Gehäuse und einem Querbalken 16 durch das Lichtband hindurch verstellbar, wobei Antriebseinrichtungen für die Längsverstellung des Gehäuses entlang einer Führungsbahn 17 vorgesehen sind, aber nicht dargestellt

Die Belichtung des Substrates 12 wird durch die Verstellgeschwindigkeit des Gehäuses 15 durch das Lichtband 14, die Lichtstärke der Lampe 1 und durch die wirksame Breite der Schlitzblende 11 bestimmt. Der Verlauf der Längsränder des Lichtstreifens 14 kann ebenfalls über die Schlitzblende 11 eingestellt werden.

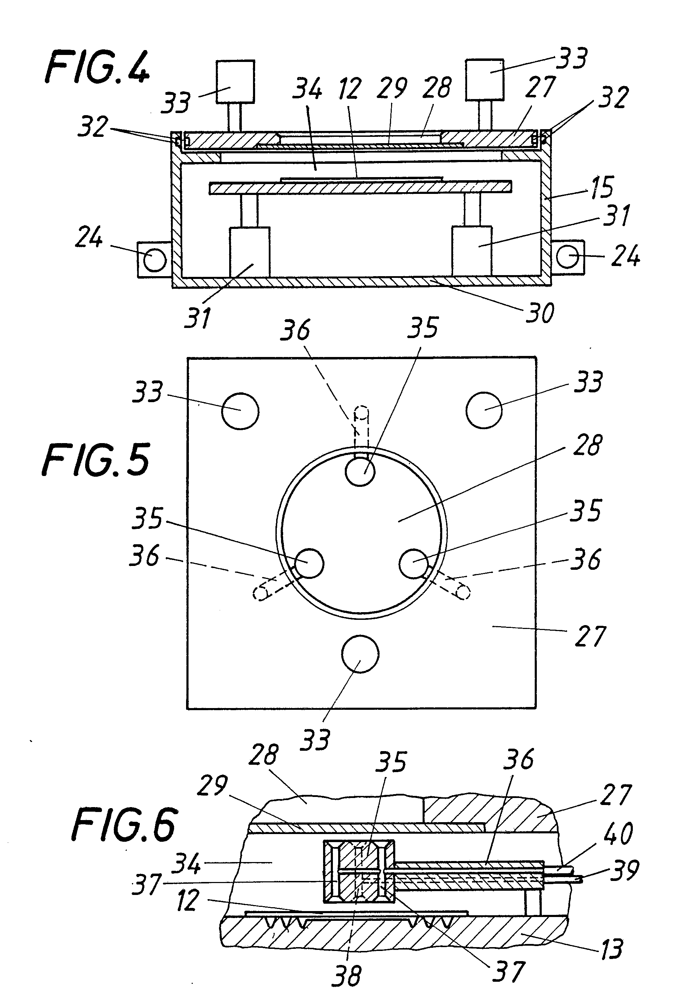

Wie Fig. 3 zeigt, sind in der Schlitzblende 11 Wandelemente 18, 19 vorgesehen, die in dem zwischen ihnen eingeschlossenen Spalt der Schlitzblende 11 nur einen Teil vom Spiegel 9 kommenden Lichtes durchlassen, der dann einen Lichtstreifen 14 bildet. Die Wandelemente 18, 19 bestehen aus biegsamen Material. In Längsabständen voneinander greifen an den Wandelementen Stößel 20 von Stelltrieben an, die aus Stellmotor-Mikrometerschraubeneinheiten 21 gebildet werden, wobei jeder Stelltrieb 20, 21 für sich einstellbar ist. Zur Steuerung der Stelltriebe 20, 21, vorzugsweise auch der nicht dargestellten Antriebseinheit, zur Längsverstellung des Gehäuses 15 durch das Lichtband 14 und zur Steuerung der im Zusammenhang mit den Fig. 4 bis 6 noch zu beschreibenden Einstelleinrichtungen für den Substratträger 13 dient ein Mikrocomputer 22. Dieser Mikrocomputer 22 erhält Signale von am Balken 16 angebrachten lichtempfindlichen Fühlern 23.

Für die Einstellung der Stelltriebe 20, 21 und damit des Verlaufes der Wandelemente 18, 19 wird wie folgt vorgegangen: Zunächst wird der Balken in die in Fig. 3 strichpunktiert angedeutete Lage verschwenkt und mit gleichbleibender Geschwindigkeit unter dem Lichtstreifen hindurchbewegt. Die lichtempfindlichen Fühler 23 werden dabei im gleichen Bereich des Lichtstreifens 14 gleich belichtet, so daß Unterschiede der an ihnen auftretenden Meßsignale ein Maß für Unterschiede in ihrer Emfpindlichkeit und in ihrer Charakteristik darstellen und im Computer 22 entsprechende Korrekturwerte gespeichert werden können, mit denen die einzelnen Meßsignale beim Normalbetrieb korrigiert werden. Nach dieser Ermittlung der Kenndaten der lichtempfindlichen Fühler 23 wird der Balken 16 wieder in die dargestellte Lage zurückgeschwenkt und durch den Lichtstreifen 14 geschoben. In beiden Fällen erfolgt diese Verstellung vor der Anringung einer Projektionsmaske bzw. bei außen am Gehäuse 15 angebrachten Balken 16. Die aufgrund der ermittelten Daten korrigierten Meßsignale der lichtempfindlichen Fühler 23 sind ein Maß für die auf den jeweiligen Fühler wirkende Beleuchtungsstärke. Der Mikrocomputer steuert die Stelltriebe 20, 21 im Sinne einer Breitenverstellung, so daß der Schlitz 11 in Bereichen mit niedriger Beleuchtungsstärke breiter und in Bereichen mit höherer Beleuchtungsstärke enger gestellt wird. Man kann den Balken 16 auch mehrmals durch den Lichtstreifen 14 verstellen und durch abermalige Integration der korrigierten Meßsignale der einzelnen lichtempfindlichen Fühler 23 feststellen, ob tatsächlich an allen Meßstellen eine gleichmäßige Belichtung auftritt, also alle Meßstellen die gleiche Lichtmenge empfangen haben, und gegebenenfalls über die Strelltriebe 20, 21 Nachkorrekturen vornehmen. Wenn alle Fühler 23 dem Computer 22 eine gleichmäßige Belichtung melden, kann das Substrat 12 durch die vorgesehene Projektionsmaske hindurch, die im Zusammenhang mit den Fig. 4 bis 6 noch beschrieben wird, belichtet werden.

In Fig. 3 wurde angedeutet, daß der Computer 22 auch einen Stelltrieb 24 zur Einstellung der Verschiebegeschwindigkeit des Gehäuses 15 mit dem Substratträger 13 durch den Lichtstreifen 14 und gegebenenfalls die Versorgungsspannung der Lampe 1 steuern kann.

Für den Spiegel 9 der Projektionseinrichtung 2, 4, 7, 9 sind zwei Antriebselemente 25, 26 in Form von Piezoschwingern vorgesehen, die in der Lage sind, Schwingungen des Spiegels 9 in seiner optischen Achse zu erzeugen. Diese Schwingungen haben Amplituden in der Größenordnung von µm bzw. Bruchteilen davon. Die Piezoschwinger 25, 26 werden von der zentralen Steuereinheit 22 gesteuert. Im Bedarfsfall können Frequenz und Amplitude der von den Piezoschwingern 25, 26 erzeugten Schwingungen einzeln oder gemeinsam durch Eingriffe in den Computer 22 verändert werden, um besonderen Strukturen der verwendeten Projektionsmasken und verschiedenen Substrat-bzw. Lackstärken Rechnung zu tragen. Durch die Erzeugung der Schwingungen ändert sich der Abstand der reflektierenden Fläche des Spiegels 9 von der zu belichtenden Seite des Substrats und auch von der Projektionsmaske und es werden dadurch Beugungs- und Interferenzerscheinungen gemildert bzw. ausgeglichen.

Wie die Fig. 4 bis 6 zeigen, ist das Gehäuse 15 nach oben hin durch einen Aufsatzdeckel 27 abgeschlossen, der in seinem Mittelbereich eine Öffnung 28 aufweist, die als Projektionsöffnung zur Einleitung des Lichtbandes 14 dient und die nach unten hin durch eine eingesetzte, auswechselbare Projektionsmaske 29 abgeschlossen ist, die in Rasteranordnung ein Belichtungsmuster für eine Vielzahl meist untereinander gleicher Bausteine für die Mikroelektronik trägt, die aus dem Substrat 12 erzeugt werden sollen. Der Deckel 27 nimmt gegenüber dem Gehäuse 15 in der Ruhestellung eine definierte Lage ein. In einem Bodenteil 30 des Gehäuses 15 sind an drei, ein gleichseitiges Dreieck bestimmenden Stellen Mikrometerschrauben-Stellmotoreinheiten 31 abgestützt, die eine Höhenverstellung des Substratträgers 13 ermöglichen. Die Stellmotoren der Mikrometerschrauben können als Schrittmotoren ausgebildet und von der zentralen Steuereinheit 22 gesteuert werden. Den Stelltrieben 31 zugeordnet sind am Deckel 27 und im Gehäuserand Lagefühler 32 aus einem Dauermagneten an dem einen und einer Hallsonde an dem anderen Teil zugeordnet. Jeder dieser Lagefühler 32 erzeugt ein Signal, das der momentanen Relativstellung des Deckels 27 zum Gehäuse 15 entspricht, der zentralen Steuereinheit 22 zugeführt und dort weiter verarbeitet wird. Die Signale bei ruhendem, aufgesetztem Deckel 27 geben die Ausgangslage des Deckels 27 an. Die zentrale Steuereinheit ist mit den Stellmotoren der Stelltriebe 31 verbunden und gibt Steuerimpulse für diese Stellmotoren ab, wobei jeder Impuls einen Drehschritt des zugehörigen Motors erzeugen kann und eine Steuerung auch der Drehrichtung möglich ist.

Der Deckel 27 ist in seinem Gewicht durch Hubeinrichtungen, vorzugsweise ein- und ausschaltbare Hubeinrichtungen 33, die z. B. pneumatische Hubeinrichtungen sein können, zum Großteil abgeglichen, so daß auch ein schwerer Deckel 27 durch geringe zusätzlich auf ihn wirkende Kräfte bewegt werden kann.

Nach einer Möglichkeit für die Relativeinstellung des Substrates 12 zur Projektionsmaske 29 wird der Substratträger 13 über die Stelltriebe 31 an den Deckel 27 herangefahren, bis das Substrat 12 gegen die Projektionsmaske 29 drückt. Bei einem durch Schräglagen der Projektionsmaske 29 oder der Oberseite des Substrates 12 bedingten Keilfehler wird der der Erstberührung vom Substrat 12 und Maske 29 nächstliegende Lagefühler 32 eine Signaländerung erfahren, da hier der Deckel 27 zunächst angehoben wird. Die zentrale Steuereinheit 22 wird den zugeordneten Stelltrieb 31 abschalten, die anderen Stelltriebe aber weiter im Anhebesinn betätigen, so daß die ihnen zugeordneten Lagefühler 32 nacheinander ansprechen. Damit ist der erste Schritt der näherungsweisen Heranführung des Substrates 12 an die Projektionsmaske 29 erreicht. Über die zentrale Steuereinheit 22 werden nun in einem Approximationsverfahren die Stelltriebe 31 einzeln in kleinen Schritten vor- bzw. zurückgestellt, bis ein Abgleich erreicht ist, d. h. der Deckel 27 wieder die Ausgangslage oder eine dazu parallele Hublage einnimmt und von allen drei Stelltrieben 31 mit gleichem Druck beaufschlagt wird. Dieser Zustand gibt die Gewähr dafür, daß die Oberseite des Substrates 12 mit gleichmäßigem Anpreßdruck an der Projektionsmaske 13 anliegt. Bei ruhendem Deckel kann nun auch eine Parallelverstellung des Substrates 12 mit dem Substratträger auf einen Sollabstand von der Maske 29 vorgenommen werden, wonach die Exponierung in der beschriebenen Weise erfolgt.

Im Zusammenhang mit den 5 und 6 wird eine noch feinfühligere Variante der Einstellungseinrichtung für den Substratträger beschrieben. Nach dieser Variante entspricht zunächst der grundsätzliche Aufbau jenem der Fig. 4. Es sind aber in den Spalt zwischen Substratträger 13 und Projektionsmaske 29 hineinverstellbare Meßfühler 35 vorgesehen, die aus an Schwenkarmen 36 sitzenden Düsenköpfen bestehen. Jeder dieser Meßfühler 35 besitzt gemäß Fig. 6 vertikale Längsbohrungen 37, 38, die sich zu Düsenöffnungen erweitern, welche gegen die Projektionsmaske 29 und den Substratträger 13 bzw. das auf diesem aufliegende Substrat gerichtet sind. Die Bohrungen 37 stehen mit einer zu einem Druckfühler führenden Meßleitung 39 und die Bohrung 38 mit einer Druckluftleitung 40 in Verbindung. Über die Leitung 40 wird beim Meßvorgang Druckluft zugeführt, die zwischen den zum Substrat und zur Maske gerichteten Oberflächen des Fühlers 35 und dem Substrat bzw. der Maske Druckluftpolster aufbaut, deren Überdruck zum einen vom Druck der über die Leitung 40 zugeführten Luft und zum anderen vom Abstand der nächstliegenden Oberfläche des Substrates, Substratträgers oder der Projektionsmaske 29 abhängt. Somit ist der auftretende Druck ein Maß für diesen Abstand. Der Druck kann daher als Parameter zur Einstellung eines definierten Abstandes zwischen der Oberfläche des Substrates 12 und der zum Substrat weisenden Oberfläche der Maske 29 verwendet werden. Auch hier ist es möglich, bei entsprechend gelenkig aufgehängten Meßfühlern 35 mit dem Substratträger bzw. dem aufliegenden Substrat an die Fühler 35 heranzufahren und die Fühler 35 bis zur Fastanlage an der Maske 29 zu verstellen, wobei bei einer zu großen Annäherung nach die Fühler 32 ansprechen werden. Für die Belichtung werden die Fühler 35 um die Arme 36 ausgeschwenkt.

## Patentansprüche

1. Belichtungseinrichtung für lichtempfindliche Materialien, insbesondere für Halbleitersubstrate (12), bei der Herstellung von Bausteinen für die Mikroelektronik mit wenigstens einer Lampe (1) mit nachgeordneter Projektionseinrichtung (2, 4, 7, 9) zur flächigen Belichtung des auf einem Substratträger (13) abstützbaren Substrates (12) durch eine ein Belichtungsmuster bestimmende Projektionsmaske (29), dadurch gekennzeichnet, daß eine einen wenigstens in einer Richtung nur über einen Bruchteil der zu belichtenden Fläche des Substratträgers (13) reichenden Lichtstreifen (14) erzeugende Projektionseinrichtung (2, 4, 7, 9, 11) vorgesehen ist, daß der Substratträger (13) mit dem Substrat (12) über Stelleinrichtungen (31) in eine Sollage gegenüber der Projektionsmaske (29) ausrichtbar und gemeinsam mit diesen quer zum erzeugten Lichtstreifen (14) verschiebbar angebracht ist, so daß der Lichtstreifen bei der Verstellung den gesamten zu belichtenden Bereich des gegenüber der Projektionsmaske ausgerichteten Substrates bestreicht, und daß im Projektionsweg (3, 5, 8, 10) wenigstens für den einen Längsrand des Lichtstreifens Stellglieder (18, 19) zur teilweisen Abschattung von Randbereichen und/oder zur Veränderung der Randform des auf das Substrat auftreffenden Lichtstreifens und damit der für die Belichtung wirksamen Breite des Lichtstreifens in dessen verschiedenen Längsbereichen vorgesehen sind.

2. Belichtungseinrichtung nach Anspruch 1, dadurch gekennzeichnet, daß die Stellglieder aus einstellbaren Wandelementen (18, 19) einer im Projektionsweg des Lichtstreifens (14) angebrachten Schlitzblende bestehen.

3. Belichtungseinrichtung nach den Ansprüchen 1 und 2, dadurch gekennzeichnet, daß die die Stellglieder bildenden Wandelemente (18, 19) über eine Längsseite der Projektion des Lichtstreifens (14) reichen, aus biegsamen Material bestehen und mit Hilfe mehrerer, für sich einstellbarer und abstandsweise entlang der Längsseite des projizierten Lichtstreifens vorgesehener Stelltriebe (20, 21) einstellbar sind.

4. Belichtungseinrichtung nach Anspruch 3, dadurch gekennzeichnet, daß die Stelltriebe aus von Stellmotoren (21) angetriebenen Mikrometerschrauben (20) bestehen.

5. Belichtungseinrichtung nach einem der Ansprüche 1 bis 4, dadurch gekennzeichnet, daß zur Messung der Beleuchtungsstärke mehrere, mit dem Substratträger (13) in den projizierten Lichtstreifen (14) hinein verschiebbare, über die Länge dieses Lichtstreifens verteilte lichtempfindliche Fühler (23) vorgesehen und mit einer zentralen Steuereinheit (22) für die Stelltriebe (20, 21) verbunden sind, so daß die Steuereinheit bei der Belichtung die Schlitzbreite in den einzelnen Längsbereichen im Sinne der Abgabe untereinander gleich großer Lichtmengen an die belichteten Bereiche einstellt.

6. Belichtungseinrichtung nach Anspruch 5, dadurch gekennzeichnet, daß die lichtempfindlichen Fühler (23) auf einem gemeinsamen Träger (16) angebracht sind, der zur Erfassung der Kenndaten dieser Fühler am Substratträger (13) aus der zum Lichtstreifen (14) etwa parallelen Arbeitsstellung in eine Querlage verstellbar ist, in der die lichtempfindlichen Fühler bei der Relativverschiebung des Lichtstreifens zum Substratträger vom gleichen Längsabschnitt des Lichtstreifens belichtet werden.

7. Belichtungseinrichtung nach einem der Ansprüche 1 bis 6, dadurch gekennzeichnet, daß bei einer die belichtete Fläche mit Parallellicht beleuchteten Projektionseinrichtung (2, 4, 6, 7, 9) wenigstens ein optisches Glied (9) in der und/ oder quer zur Projektionsachse mit hoher Frequenz und kleiner, insbesondere in der Größenordnung μm oder Bruchteilen davon liegender Amplitude schwingend antreibbar ist.

8. Belichtungseinrichtung nach Anspruch 7, dadurch gekennzeichnet, daß für den schwingenden Antrieb mit dem op tischen Glied (9) gekuppelte, von der zentralen Steuereinheit (22) aus erregbare Piezoschwinger (25, 26) vorgesehen sind.

9. Belichtungseinrichtung nach Anspruch 7 oder 8, dadurch gekennzeichnet, daß die Projektionseinrichtung zwei nur in der einen Ebene gewölbte Parabolspiegel (7, 9) aufweist, die bezüglich der Projektionsachse gegeneinander um 90° verdreht sind und von denen der erste (7) ein ihm von einer Lampe (1) über Reflektoren (2, 4) zugeleitetes, konzentrisches divergierendes Lichtbündel (4, 5) empfängt und als divergierendes Lichtband (8) zum zweiten Parabolspiegel (9) reflektiert, der es als paralleles streifenförmiges Lichtband (10) mit Parallellicht abstrahlt.

10. Belichtungseinrichtung nach den Ansprüchen 7 bis 9, dadurch gekennzeichnet, daß der eine Parabolspiegel (9) das schwingend antreibbare Glied bildet.

11. Belichtungseinrichtung nach einem der Ansprüche 1 bis 10, dadurch gekennzeichnet, daß der Substratträger (13) in einem über Antriebseinrichtungen (24) durch den Lichtstreifen (14) verstellbaren Gehäuse (15) untergebracht und über wenigstens drei von Stellmotoren angetriebene Mikrometerschrauben (31) relativ zu der in einem Gehäusedeckel (27) anbringbaren Projektionsmaske (29) im Sinne der Einstellung einer Sollstellung insbesondere Parallelstellung seiner bzw. der Oberseite des Substrates (12) zu dieser Projektionsmaske (29) verstellbar ist, wobei Fühler (32, 35) zur Erfassung der momentanen Lage der Oberseite des Substrates vorgesehen und mit einer die einzelnen Stelltriebe (31) im Sinne einer näherungsweisen Nachführungsteuerung bis zum Erreichen der Sollstellung betätigenden zentralen Steuereinheit (22) verbunden sind.

12. Belichtungseinrichtung nach Anspruch 11, dadurch gekennzeichnet, daß der die Projektionsmaske (29) tragende Gehäusedeckel (27) über den von unten an ihn anstellbaren Substratträger (13) bzw. das auf diesem aufliegende Substrat (12) aus seiner Ruhelage abhebbar ist und die Fühler (32) die Relativverstellung des Deckels gegenüber der Ruhelage erfassen.

13. Belichtungseinrichtung nach Anspruch 12, dadurch gekennzeichnet, daß ein- und ausschaltbare Hubeinrichtungen (33) für den Deckel (27) vorgesehen sind, die im Einschaltzustand den Großteil des Deckelgewichtes abgleichen, so daß der Deckel unter geringem Anpreßdruck durch Substratträger (13) und Substrat (12) verstellbar ist.

14. Belichtungseinrichtung nach einem der Ansprüche 11 bis 13, dadurch gekennzeichnet, daß der Substratträger (13) nach Einstellung einer einer möglichen Keilform des Substrates (12) entsprechenden Neigung über die von der zentralen Steuereinheit (22) gesteuerten Stelltriebe (31) parallel zu sich selbst auf wählbare Abstände von der Projektionsmaske (29) einstellbar ist.

15. Belichtungseinrichtung nach den Ansprüchen 12 bis 14, dadurch gekennzeichnet, daß die Meßfühler (32) als Hallsonden mit zugeordneten Erregermagneten ausgebildet sind, die ein sich mit der Relativverstellung von Magnet und Sonde änderndes Signal erzeugen.

16. Belichtungseinrichtung nach Anspruch 11, dadurch gekennzeichnet, daß bei auf Abstand von der Projektionsmaske (29) eingestelltem Substratträger (13) in den Spalt (34) zwischen Maske und Substratträger Meßsonden (35) einführbar sind, die Austrittsdüsen für ein unter vorgegebenem Druck zugeführtes Gas und Druckfühler (37) zur Erfassung des Überdruckes des im Spaltraum durch die Gaszufuhr erzeugten Gaspolsters aufweisen und die der Steuereinheit (22) diesem Druck entsprechende Signale zuführen.

17. Belichtungseinrichtung nach Anspruch 16, dadurch gekennzeichnet, daß zunächst über die Meßfühler (35) der Druck bei in eine Sollebene zur Projektionsmaske (29) eingestelltem Substratträger (13) erfaßt und die entsprechenden Meßsignale festgehalten werden und daß nach Auflegen des Substrates (12) auf den Substratträger (13) dieser über die Stelltriebe (31) bis zum Auftreten der vorher gespeicherten Druckwerte eingestellt wird.

18. Belichtungseinrichtung nach den Ansprüchen 16 und 17, dadurch gekennzeichnet, daß die Meßfühler (35) sowohl zum Substratträger (13) als auch zur Projektionsmaske (29) gerichtete Austrittsöffnungen (38) für das Druckgas und entsprechende mit Druckmeßeinrichtungen verbundene Eintrittsöffnungen (37) aufweisen.

19. Belichtungseinrichtung nach einem der Ansprüche 16 bis 18, dadurch gekennzeichnet, daß die Meßfühler (35) an Armen (36) befestigt sind, die um zur Projektionsmaske (29) normale Achsen in die und aus der Arbeitsstellung über dem Auflagebereich des Substrates (12) verschwenkbar sind.

# FIG.1

# FIG.2

# FIG.3

FIG.4

FIG.5

FIG.6